# EUROPÄISCHE PATENTANMELDUNG

(11) **EP 2 485 398 A1**
(43) Veröffentlichungstag der Anmeldung: **08.08.2012**
(21) Anmeldenummer: 11000868.7
(22) Anmeldetag: 03.02.2011
(51) Int. Cl.: H03J 7/02, G07C 9/00

(54) **Komfort- und/oder Zugangskontrollsystem**

(71) Anmelder: Delphi Technologies, Inc., Troy MI 48007 (US)
(72) Erfinder: Doerr, Wolfgang, 51674 Wiehl (DE)
(74) Vertreter: Manitz, Finsterwald & Partner GbR

(57) **Zusammenfassung**

Ein Komfort- und/oder Zugangskontrollsystem insbesondere für Fahrzeuge umfasst eine elektronische Steuereinrichtung, eine Benutzer- und/oder Sensoreinrichtung und der elektronischen Steuereinrichtung sowie der Benutzer- und/oder Sensoreinrichtung zugeordnete Mittel für eine Funk-Kommunikation zwischen der Steuereinrichtung und der Benutzer-und/oder Sensoreinrichtung. Der Steuereinrichtung sind Messmittel zugeordnet, durch die ein eventueller Frequenzversatz zwischen der Trägerfrequenz eines von der Benutzer- und/oder Sensoreinrichtung ausgesandten, von der Steuereinrichtung empfangenen Anforderungssignals und der Frequenz eines der Steuereinrichtung zugeordneten Oszillators gemessen wird. Die Steuereinrichtung umfasst Kompensationsmittel, durch die Frequenz des der Steuereinrichtung zugeordneten Oszillators zur Erzeugung der Trägerfrequenz eines von der Steuereinrichtung auszusendenden Bestätigungssignals in Abhängigkeit vom gemessenen Frequenzversatz variabel so einstellbar ist, dass der Frequenzversatz bezüglich der Trägerfrequenz des Bestätigungssignals und der Trägerfrequenz des Anforderungssignals kompensiert wird.

## Beschreibung

Die vorliegende Erfindung betrifft ein Komfort- und/oder Zugangskontrollsystem insbesondere für Fahrzeuge, mit einer elektronischen Steuereinrichtung, einer Benutzer- und/oder Sensoreinrichtung und der elektronischen Steuereinrichtung sowie der Benutzer- und/oder Sensoreinrichtung zugeordneten Mitteln für eine Funk-Kommunikation zwischen der Steuereinrichtung und der Benutzer- und/oder Sensoreinrichtung. Das System kann insbesondere einen oder mehrere Funkdienste im Automobilbereich umfassen, die sich nicht nur auf den Fahrzeugzugang, sondern z.B. auch auf folgendes beziehen können: Reifendruck, Standheizung, Motorstart, Entertainment-Control, Remote-Control usw.

Ein solches Komfort- und/ oder Zugangskontrollsystem kommt beispielsweise dort zum Einsatz, wo es um die Überprüfung geht, ob eine jeweilige Person als Inhaber einer jeweiligen Identifikationseinrichtung autorisiert ist, die betreffende Zugangskontrolleinrichtung zu passieren. Dies kann sowohl für ortsfeste Zugangskontrolleinrichtungen, zu denen nur ein ausgewählter Personenkreis Zutritt hat, als auch für mobile Zugangskontrolleinrichtungen, insbesondere bei Fahrzeugen wie zum Beispiel Kraftfahrzeugen, Schiffen oder Fahrrädern, gelten. Mit den betreffenden Zugangskontrolleinrichtungen soll hier insbesondere einem Diebstahl des betreffenden Fahrzeugs entgegengewirkt werden.

Das jeweilige Komfort- und/oder Zugangskontrollsystem kann insbesondere auch als sogenanntes schlüsselloses Zugangssystem und/oder schlüsselloses Startsystem für Fahrzeuge vorgesehen sein. Es umfasst in diesem Fall als zugangsseitige Steuereinrichtung ein dem Fahrzeug zugeordnetes elektronisches Steuergerät, welches in der Regel dauerhaft mit Energie versorgt wird, und wenigstens eine mobile Identifikationseinrichtung, die einen jeweiligen autorisierten Benutzer identifizieren soll. Dabei kann eine jeweilige Identifikationseinrichtung selbst Teil eines Fahrzeugschlüssels sein, der mit der Steuereinrichtung im Bereich der Schließ- und/oder Startanlage des Fahrzeugs in vorzugsweise bidirektionalem Datenaustausch steht. Die jeweiligen Identifikationseinrichtungen können insbesondere auch in Chipkarten oder dergleichen integriert und beispielsweise als Transponder ausgeführt sein. Transponder weisen keine eigene Energieversorgung auf, sie werden vielmehr bei einer Annäherung der Identifikationseinrichtung an die Steuereinrichtung drahtlos mit Energie versorgt und im Weiteren automatisch zur Übertragung der Authentisierungsantwortsignale angesprochen.

Das wichtigste Leistungskriterium solcher Komfort- und/oder Zugangskontrollsysteme ist der allgemein in Metern gemessene Aktionsbereich oder Reichweite um den kontrollierten Zugangsbereich, wie beispielsweise ein Fahrzeug. Diese Reichweite sowie die Kundenanforderungen treiben unter den gegebenen Einschränkungen in Bezug auf verfügbare Batterien, gesetzliche Bestimmungen und physikalische Grenzen die Kosten für die verwendeten Quarze, integrierten Schaltkreise und Antennen in die Höhe. Maßgeblich sind hierbei insbesondere Frequenztoleranzen der Quarzoszillatoren und der daraus resultierende Frequenzunterschied zwischen der Trägerfrequenz eines jeweiligen von der benutzerseitigen Identifikationseinrichtung ausgesandten Signals und der Trägerfrequenz eines jeweiligen von der zugangsseitigen elektronischen Steuereinrichtung ausgesandten Signals.

Bei Systemen für eine bidirektionale Funk-Kommunikation bringen die beiden Verbindungswege von der benutzerseitigen Identifikationseinrichtung zur zugangsseitigen elektronischen Steuereinrichtung und umgekehrt unterschiedliche Einschränkungen mit sich. Die Verbindung von der zugangsseitigen elektronischen Steuereinrichtung, zum Beispiel der eines Fahrzeugs, zu der benutzerseitigen Identifikationseinrichtung kann insbesondere der Übertragung eines Bestätigungssignals nach dem Empfang eines von der benutzerseitigen Identifikationseinrichtung ausgesandten Anforderungssignals dienen.

Der Erfindung liegt die Aufgabe zugrunde, ein verbessertes Komfort- und/oder Zugangskontrollsystem der eingangs genannten Art zu schaffen, bei dem die zuvor erwähnten Probleme beseitigt sind. Dabei soll auf einfache und wirtschaftliche Weise insbesondere eine möglichst hohe Empfindlichkeit der jeweiligen Funkverbindung gewährleistet sein.

Gemäß einem ersten Aspekt der Erfindung wird diese Aufgabe dadurch gelöst, dass der Steuereinrichtung Messmittel zugeordnet sind, durch die ein eventueller Frequenzversatz zwischen der Trägerfrequenz eines von der Benutzer- und/oder Sensoreinrichtung ausgesandten, von der Steuereinrichtung empfangenen Anforderungssignals und der Frequenz eines der Steuereinrichtung zugeordneten Oszillators gemessen wird, und dass die Steuereinrichtung Kompensationsmittel umfasst, durch die die Frequenz des der Steuereinrichtung zugeordneten Oszillators zur Erzeugung der Trägerfrequenz eines von der Steuereinrichtung auszusendenden Bestätigungssignals in Abhängigkeit vom gemessenen Frequenzversatz variabel so einstellbar ist, dass der Frequenzversatz bezüglich der Trägerfrequenz des Bestätigungssignals und der Trägerfrequenz des Anforderungssignals kompensiert wird. Umfasst das System ein Zugangskontrollsystem, so kann die elektronische Steuereinrichtung insbesondere eine zugangsseitige elektronische Steuereinrichtung und die Benutzer- und/oder Sensoreinrichtung insbesondere eine benutzerseitige Identifikationseinrichtung umfassen.

Aufgrund dieser Ausbildung wird die Empfindlichkeit insbesondere der Funkverbindung von der elektronischen Steuereinrichtung, insbesondere der eines Fahrzeugs, zur Benutzer- und/ oder Sensoreinrichtung deutlich erhöht, ohne dass dazu aufwändige und entsprechend teure Quarze oder Antennen erforderlich sind. Der bisher das Hauptproblem darstellende Frequenzversatz wird nunmehr z.B. zugangsseitig kompensiert, indem dieser zugangsseitig gemessen und die Trägerfrequenz für das von der Steuereinrichtung auszusendende Bestätigungssignal entsprechend korrigiert wird. Es wird also der Umstand genutzt, dass der Frequenzversatz zugangsseitig anhand des empfangenen, von der Benutzer- und/oder Sensoreinrichtung ausgesandten Anforderungssignals ermittelt werden kann. Dabei kann dieser Frequenzversatz insbesondere während des Empfangs des Anforderungssignals gemessen werden. Indem die Trägerfrequenz des von der Steuereinrichtung auszusenden Bestätigungssignals entsprechend korrigiert wird, kann der Frequenzversatz abgesehen von Messfehlern und eventuell anderen Unterschieden zwischen den beiden Szenarien wie beispielsweise einer leicht unterschiedlichen Versorgungsspannung praktisch vollständig kompensiert werden. Damit kann in der Benutzer- und/oder Sensoreinrichtung ein sehr schmales Filter verwendet werden, womit eine sehr hohe Empfindlichkeit und eine gute Reichweite erzielt werden.

Bevorzugt umfasst der der Steuereinrichtung zugeordnete Oszillator einen Quarzoszillator. Zur Erzeugung der Trägerfrequenz des Anforderungssignals kann auch die Benutzer- und/oder Sensoreinrichtung einen solchen Quarzoszillator umfassen. Aufgrund der erfindungsgemäßen Kompensation des Frequenzversatzes können relativ einfache und entsprechend kostengünstige Oszillatoren eingesetzt werden.

Es sind nunmehr insbesondere auch größere Oszillatortoleranzen möglich. Dabei ist die Nutzsignalbreite vorteilhafterweise schmaler als die insbesondere durch die Oszillatortoleranzen bestimmte Gesamtbandbreite des Systems. Es sind jedoch auch Ausführungen des Systems ohne Quarz möglich, zumal die hierbei auftretenden größeren Toleranzen erfindungsgemäß komprimiert werden können.

Gemäß einer bevorzugten praktischen Ausführungsform des erfindungsgemäßen Komfort- und/oder Zugangskontrollsystems besitzt die Benutzer- und/oder Sensoreinrichtung eine insbesondere im Vergleich zur Gesamtbandbreite des Systems schmalere Bandbreite bzw. ein entsprechend schmalbandiges Filter.

Die Frequenzmessung bzw. Messung des Frequenzversatzes kann während der Modulation erfolgen. Dabei erfolgt die Frequenzmessung bzw. Messung des Frequenzversatzes bevorzugt synchron zum Symboltakt. Damit kann die Messung insbesondere in Kenntnis des jeweiligen Modulationszustands erfolgen. Grundsätzlich ist jedoch auch eine Messung ohne Modulation möglich. Dazu kann die Benutzereinrichtung, z.B. Schlüssel, anfangs ein unmoduliertes Signal aussenden.

Die im Rahmen der Messung erhaltene Information kann für den darauffolgenden Empfang von Nutzsignalen bzw. Anforderungssignalen von derselben Benutzer- und/oder Sensoreinrichtung genutzt werden.

Die erfindungsgemäße Frequenzversatz-Kompensation bringt also insbesondere für die Funkverbindung von der Sensoreinrichtung, beispielsweise der eines Fahrzeugs, zur Benutzer- und/oder Steuereinrichtung Vorteile wie insbesondere eine höhere Empfindlichkeit mit sich. Dabei erhöht sich die Empfindlichkeit insbesondere für Funkverbindungen von Komfort- und/oder Zugangskontrollsystemen, bei denen die Nutzsignalbandbreite wesentlich schmaler ist als die Gesamtbandbreite des Systems, die typischerweise durch die Oszillatortoleranzen bestimmt ist.

Die Benutzer- und/oder Sensoreinrichtung muss einen eventuellen Frequenzversatz zwischen Sender und Empfänger bewältigen. Die Übertragungssequenz beginnt beispielsweise bei der Benutzer- und/oder Sensoreinrichtung, wobei der Frequenzversatz beträchtliche Toleranzen aufweisen kann. Der betreffende Frequenzversatz kann dann z.B. zugangsseitig, insbesondere fahrzeugseitig, während des Empfangs gemessen werden, wodurch die Möglichkeit geschaffen wird, die Übertragung eines Bestätigungssignals mit kompensiertem Frequenzversatz auszusenden. Damit kann die Benutzer- und/oder Sensoreinrichtung eine wesentlich schmalere Bandbreite besitzen, wodurch der durchgelassene Rauschanteil reduziert wird, so dass insbesondere auch schwächere Signale empfangen werden können. Dies ist insbesondere insoweit von Vorteil, als die Verbindung von der Benutzer- und/oder Sensoreinrichtung zur insbesondere zugangsseitigen, zum Beispiel fahrzeugseitigen elektronischen Steuereinrichtung deutlich schwächer ist als die von der elektronischen Steuereinrichtung zu der Benutzer- und/oder Sensoreinrichtung, da die Benutzer-und/oder Sensoreinrichtung in der Regel keinen Vorverstärker besitzt.

Die Frequenzmessung kann während der Modulation erfolgen. Dabei kann der Symboltakt dazu benutzt werden, die Messung während bestimmter Modulationszustände vorzunehmen und beispielsweise die Modulation zu kompensieren.

Gemäß einem weiteren Aspekt der Erfindung wird die zuvor genannte Aufgabe dadurch gelöst, dass die Gesamtbandbreite des Systems größer ist als die Nutzsignalbandbreite, dass die Steuereinrichtung mehrere Empfangsunterkanäle umfasst, deren Bandbreite jeweils schmaler ist als die Gesamtbandbreite des Systems, und dass die Steuereinrichtung Kanalabtastmittel umfasst, durch die die verschiedenen Empfangsunterkanäle daraufhin abgetastet werden, ob ein empfangenes, von der Benutzer-und/oder Sensoreinrichtung ausgesandtes Nutzsignal innerhalb deren Bandbreite liegt, um den betreffenden Empfangsunterkanal auszuwählen. In diesem Fall kann es sich allgemein um ein unidirektionales oder um ein bidirektionales Funksystem handeln. Ein solches Funksystem kann beispielsweise auch eine Reifendruckkontrolle und/oder dergleichen enthalten. Dabei kann die Sensoreinrichtung beispielsweise einen Reifendrucksensor oder dergleichen umfassen.

Aufgrund dieser Ausbildung wird auf einfache und wirtschaftliche Weise insbesondere die Empfindlichkeit der Funkverbindung von der Benutzer-und/oder Sensoreinrichtung zur zugangsseitigen elektronischen Steuereinrichtung erhöht, ohne dass dazu aufwändige und entsprechend kostspielige Quarze oder Antennen erforderlich sind.

Bei dem von der Benutzer- und/oder Sensoreinrichtung ausgesandten Nutzsignal kann es sich insbesondere um ein Anforderungssignal handeln.

Gemäß einer bevorzugten Ausführungsform des erfindungsgemäßen Komfort- und/oder Zugangskontrollsystems gemäß dem zweiten Aspekt sind der Steuereinrichtung Messmittel zugeordnet, durch die die Trägerfrequenz von empfangenen, von der Benutzer- und/oder Sensoreinrichtung ausgesandten Nutzsignalen gemessen wird, wobei die Steuereinrichtung Mittel umfasst, durch die ein jeweiliger Empfangsunterkanal auf das jeweilige Nutzsignal zentriert wird.

Von Vorteil ist insbesondere auch, wenn die Steuereinrichtung Mittel umfasst, die nach erfolgter Zentrierung des Empfangsunterkanals auf das Nutzsignal die Bandbreite des Empfangsunterkanals weiter reduziert.

Für die Übertragung der Präambel des Nutzsignals kann deren Datenrate reduziert sein.

Bevorzugt ist die Datenrate während der Präambel des Nutzsignals insbesondere im Vergleich zu dessen restlicher Datenrate reduziert.

Durch die erfindungsgemäße Kanalabtastung wird die Empfindlichkeit von Funkverbindungen insbesondere solcher Systeme verbessert, bei denen die Bandbreite des Nutzsignals deutlich schmaler ist als die Gesamtbandbreite des Systems, die typischerweise durch die Oszillatortoleranzen definiert ist. Die Empfangsunterkanäle, die auf die Nutzsignale hin abgetastet werden, besitzen jeweils eine schmalere Bandbreite als die Gesamtbandbreite des Systems. Die schmalere Bandbreite bringt unter anderem den Vorteil mit sich, dass das Rauschen reduziert wird und der insgesamt geringere Rauschpegel den Empfang schwächerer Signale ermöglicht. Es kann eine Frequenzmessung schwächerer Nutzsignale zur Zentrierung des nächsten Unterkanals für das Nutzsignal verwendet werden. Nach der Frequenzausrichtung kann die Bandbreite weiter reduziert werden, um insbesondere die Bit-Fehlerrate während der Nutzinformation des Telegramms zu reduzieren.

Es kann die Datenrate während der Präambel des Nutzsignals bzw. Telegramms reduziert werden, um die Empfindlichkeit in dieser kritischen Phase zu erhöhen. So resultiert beispielsweise ein Bitmuster "0101..." der Manchester-Codierung im Vergleich zum herkömmlichen Bitmuster "1111..." in der halben physikalischen Datenrate.

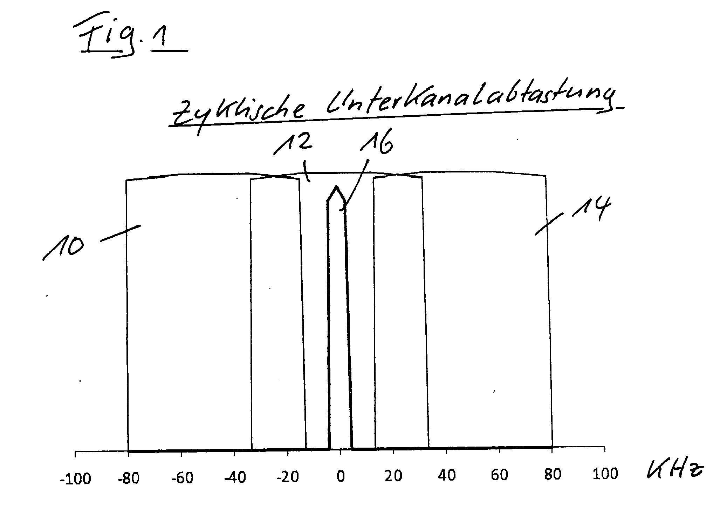

In dem Diagramm der einzigen Figur der Zeichnung ist ein Beispiel einer möglichen Kanalabtastung wiedergegeben.

Danach beträgt die Gesamtbandbreite des Systems zum Beispiel +/- 80 kHz, während drei Empfangsunterkanäle 10 bis 14 mit einer jeweiligen Bandbreite von beispielsweise +/- 35 kHz vorgesehen sind. Dabei kann eine zyklische Abtastung der Gesamtbandbreite über die Empfangsunterkanäle 10 bis 14 erfolgen. Beim vorliegenden Ausführungsbeispiel überlagern sich der erste Empfangsunterkanal 10 und der mittlere Empfangsunterkanal 12 teilweise. Zudem überlagern sich auch der mittlere Empfangsunterkanal 14 und der dritte Empfangsunterkanal 14 teilweise. Das eine deutlich geringere Bandbreite als die Empfangsunterkanäle 10 bis 14 aufweisende Nutzsignal 16 liegt hier zentral innerhalb des mittleren bzw. zweiten Empfangsunterkanals 12.

### Bezugszeichenliste

- 10: erster Empfangsunterkanal
- 12: zweiter bzw. mittlerer Empfangsunterkanal
- 14: dritter Empfangsunterkanal
- 16: Nutzsignal

## Patentansprüche

1. Komfort- und/oder Zugangskontrollsystem insbesondere für Fahrzeuge, mit einer elektronischen Steuereinrichtung, einer Benutzer-und/oder Sensoreinrichtung und der elektronischen Steuereinrichtung sowie der Benutzer- und/oder Sensoreinrichtung zugeordneten Mitteln für eine Funk-Kommunikation zwischen der Steuereinrichtung und der Benutzer- und/oder Sensoreinrichtung,
**dadurch gekennzeichnet,**
**dass** der Steuereinrichtung Messmittel zugeordnet sind, durch die ein eventueller Frequenzversatz zwischen der Trägerfrequenz eines von der Benutzer- und/oder Sensoreinrichtung ausgesandten, von der Steuereinrichtung empfangenen Anforderungssignals und der Frequenz eines der Steuereinrichtung zugeordneten Oszillators gemessen wird, und dass die Steuereinrichtung Kompensationsmittel umfasst, durch die die Frequenz des der Steuereinrichtung zugeordneten Oszillators zur Erzeugung der Trägerfrequenz eines von der Steuereinrichtung auszusendenden Bestätigungssignals in Abhängigkeit vom gemessenen Frequenzversatz variabel so einstellbar ist, dass der Frequenzversatz bezüglich der Trägerfrequenz des Bestätigungssignals und der Trägerfrequenz des Anforderungssignals kompensiert wird.

2. Komfort- und/oder Zugangskontrollsystem nach Anspruch 1,
**dadurch gekennzeichnet,**
**dass** der der Steuereinrichtung zugeordnete Oszillator einen Quarzoszillator umfasst.

3. Komfort- und/oder Zugangskontrollsystem nach Anspruch 1 oder 2,
**dadurch gekennzeichnet,**
**dass** die Benutzer- und/oder Sensoreinrichtung zur Erzeugung der Trägerfrequenz des Anforderungssignals einen Quarzoszillator umfasst.

4. Komfort- und/oder Zugangskontrollsystem nach einem der vorhergehenden Ansprüche,
**dadurch gekennzeichnet,**
**dass** die Nutzsignalbandbreite schmaler ist als die insbesondere durch die Oszillatortoleranzen bestimmte Gesamtbandbreite des Systems.

5. Komfort- und/oder Zugangskontrollsystem nach einem der vorhergehenden Ansprüche,
**dadurch gekennzeichnet,**
**dass** die Benutzer- und/oder Sensoreinrichtung eine insbesondere im Vergleich zur Gesamtbandbreite des Systems schmalere Bandbreite besitzt bzw. ein entsprechend schmalbandiges Filter umfasst.

6. Komfort- und/oder Zugangskontrollsystem nach einem der vorhergehenden Ansprüche,
**dadurch gekennzeichnet,**
**dass** die Frequenzmessung bzw. Messung des Frequenzversatzes während der Modulation erfolgt.

7. Komfort- und/oder Zugangskontrollsystem nach Anspruch 6,
**dadurch gekennzeichnet,**
**dass** die Frequenzmessung bzw. Messung des Frequenzversatzes synchron zum Symboltakt erfolgt.

8. Komfort- und/oder Zugangskontrollsystem insbesondere für Fahrzeuge, mit einer elektronischen Steuereinrichtung, einer Benutzer-und/oder Sensoreinrichtung und der elektronischen Steuereinrichtung sowie der Benutzer- und/oder Sensoreinrichtung zugeordneten Mitteln für eine Funk-Kommunikation zwischen der Steuereinrichtung und der Benutzer- und/oder Sensoreinrichtung, insbesondere nach einem der vorhergehenden Ansprüche,
**dadurch gekennzeichnet,**
**dass** die Gesamtbandbreite des Systems größer ist als die Nutzsignalbandbreite, dass die Steuereinrichtung mehrere Empfangsunterkanäle (10 - 14) umfasst, deren Bandbreite jeweils schmaler ist als die Gesamtbandbreite des Systems, und dass die Steuereinrichtung Kanalabtastmittel umfasst, durch die die verschiedenen Empfangsunterkanäle (10 - 14) daraufhin abgetastet werden, ob ein empfangenes, von der Benutzer- und/oder Sensoreinrichtung ausgesandtes Nutzsignal (16) innerhalb deren Bandbreite liegt, um den betreffenden Empfangsunterkanal auszuwählen.

9. Komfort- und/oder Zugangskontrollsystem nach Anspruch 8,
**dadurch gekennzeichnet,**
**dass** das von der Benutzer- und/oder Sensoreinrichtung ausgesandte Nutzsignal (16) ein Anforderungssignal ist.

10. Komfort- und/oder Zugangskontrollsystem nach Anspruch 8 oder 9,
**dadurch gekennzeichnet,**
**dass** der Steuereinrichtung Messmittel zugeordnet sind, durch die die Trägerfrequenz von empfangenen, von der Benutzer- und/oder Sensoreinrichtung ausgesandten Nutzsignalen (16) gemessen wird, und dass die Steuereinrichtung Mittel umfasst, durch die ein jeweiliger Empfangsunterkanal auf das jeweilige Nutzsignal (16) zentriert wird.

11. Komfort- und/oder Zugangskontrollsystem nach Anspruch 10,
**dadurch gekennzeichnet,**
**dass** die Steuereinrichtung Mittel umfasst, die nach erfolgter Zentrierung des Empfangsunterkanals auf das Nutzsignal (16) die Bandbreite des Empfangsunterkanals weiter reduziert.

12. Komfort- und/oder Zugangskontrollsystem nach Anspruch 10,
**dadurch gekennzeichnet,**
**dass** die Datenrate während der Präambel des Nutzsignals (16) insbesondere im Vergleich zu dessen restlicher Datenrate reduziert ist.

## Geänderte Patentansprüche

### Geänderte Patentansprüche gemäss Regel 137(2) EPÜ.

**1.** Komfort- und/oder Zugangskontrollsystem insbesondere für Fahrzeuge, mit einer elektronischen Steuereinrichtung, einer Benutzer- und/oder Sensoreinrichtung und der elektronischen Steuereinrichtung sowie der Benutzer- und/oder Sensoreinrichtung zugeordneten Mitteln für eine Funk-Kommunikation zwischen der Steuereinrichtung und der Benutzer- und/oder Sensoreinrichtung,
**dadurch gekennzeichnet,**
**dass** der Steuereinrichtung Messmittel zugeordnet sind, durch die ein eventueller Frequenzversatz zwischen der Trägerfrequenz eines von der Benutzer- und/oder Sensoreinrichtung ausgesandten, von der Steuereinrichtung empfangenen Anforderungssignals und der Frequenz eines der Steuereinrichtung zugeordneten Oszillators gemessen wird, dass die Steuereinrichtung Kompensationsmittel umfasst, durch die die Frequenz des der Steuereinrichtung zugeordneten Oszillators zur Erzeugung der Trägerfrequenz eines von der Steuereinrichtung auszusendenden Bestätigungssignals in Abhängigkeit vom gemessenen Frequenzversatz variabel so einstellbar ist, dass der Frequenzversatz bezüglich der Trägerfrequenz des Bestätigungssignals und der Trägerfrequenz des Anforderungssignals kompensiert wird, und dass die Nutzsignalbandbreite schmaler ist als die insbesondere durch die Oszillatortoleranzen bestimmte Gesamtbandbreite des Systems.

**2.** Komfort- und/oder Zugangskontrollsystem nach Anspruch 1,
**dadurch gekennzeichnet,**
**dass** der der Steuereinrichtung zugeordnete Oszillator einen Quarzoszillator umfasst.

**3.** Komfort- und/oder Zugangskontrollsystem nach Anspruch 1 oder 2,
**dadurch gekennzeichnet,**
**dass** die Benutzer- und/oder Sensoreinrichtung zur Erzeugung der Trägerfrequenz des Anforderungssignals einen Quarzoszillator umfasst.

**4.** Komfort- und/oder Zugangskontrollsystem nach einem der vorhergehenden Ansprüche,
**dadurch gekennzeichnet,**
**dass** die Benutzer- und/oder Sensoreinrichtung eine insbesondere im Vergleich zur Gesamtbandbreite des Systems schmalere Bandbreite besitzt bzw. ein entsprechend schmalbandiges Filter umfasst.

**5.** Komfort- und/oder Zugangskontrollsystem nach einem der vorhergehenden Ansprüche,
**dadurch gekennzeichnet,**
**dass** die Frequenzmessung bzw. Messung des Frequenzversatzes während der Modulation erfolgt.

**6.** Komfort- und/oder Zugangskontrollsystem nach Anspruch 5,
**dadurch gekennzeichnet,**
**dass** die Frequenzmessung bzw. Messung des Frequenzversatzes synchron zum Symboltakt erfolgt.

**7.** Komfort- und/oder Zugangskontrollsystem insbesondere für Fahrzeuge, mit einer elektronischen Steuereinrichtung, einer Benutzer- und/oder Sensoreinrichtung und der elektronischen Steuereinrichtung sowie der Benutzer- und/oder Sensoreinrichtung zugeordneten Mitteln für eine Funk-Kommunikation zwischen der Steuereinrichtung und der Benutzer- und/oder Sensoreinrichtung, insbesondere nach einem der vorhergehenden Ansprüche,
**dadurch gekennzeichnet,**
**dass** die Gesamtbandbreite des Systems größer ist als die Nutzsignalbandbreite, dass die Steuereinrichtung mehrere Empfangsunterkanäle (10 - 14) umfasst, deren Bandbreite jeweils schmaler ist als die Gesamtbandbreite des Systems, und dass die Steuereinrichtung Kanalabtastmittel umfasst, durch die die verschiedenen Empfangsunterkanäle (10 - 14) daraufhin abgetastet werden, ob ein empfangenes, von der Benutzer- und/oder Sensoreinrichtung ausgesandtes Nutzsignal (16) innerhalb deren Bandbreite liegt, um den betreffenden Empfangsunterkanal auszuwählen.

**8.** Komfort- und/oder Zugangskontrollsystem nach Anspruch 7,
**dadurch gekennzeichnet,**
**dass** das von der Benutzer- und/oder Sensoreinrichtung ausgesandte Nutzsignal (16) ein Anforderungssignal ist.

**9.** Komfort- und/oder Zugangskontrollsystem nach Anspruch 7 oder 8,
**dadurch gekennzeichnet,**
**dass** der Steuereinrichtung Messmittel zugeordnet sind, durch die die Trägerfrequenz von empfangenen, von der Benutzer- und/oder Sensoreinrichtung ausgesandten Nutzsignalen (16) gemessen wird, und dass die Steuereinrichtung Mittel umfasst, durch die ein jeweiliger Empfangsunterkanal auf das jeweilige Nutzsignal (16) zentriert wird.

**10.** Komfort- und/oder Zugangskontrollsystem nach Anspruch 9,
**dadurch gekennzeichnet,**
**dass** die Steuereinrichtung Mittel umfasst, die nach erfolgter Zentrierung des Empfangsunterkanals auf das Nutzsignal (16) die Bandbreite des Empfangsunterkanals weiter reduziert.

**11.** Komfort- und/oder Zugangskontrollsystem nach Anspruch 9,
**dadurch gekennzeichnet,**
**dass** die Datenrate während der Präambel des Nutzsignals (16) insbesondere im Vergleich zu dessen restlicher Datenrate reduziert ist.
